# EUROPEAN PATENT APPLICATION

(11) **EP 4 492 098 A1**
(43) Date of publication of application: **15.01.2025**
(21) Application number: 23815530.3
(22) Date of filing: 20.03.2023
(51) Int. Cl.: G01T 1/20, H01L 27/144, H01L 27/146, H01L 31/08, H01L 31/107, H01L 31/10

(54) **RADIATION DETECTOR AND RADIATION DETECTION DEVICE**

(30) Priority: 31.05.2022 JP 2022088411
(71) Applicant: Hamamatsu Photonics K.K., Hamamatsu-shi, Shizuoka 435-8558 (JP)
(72) Inventor: YOSHIDA Tetsuya, Hamamatsu-shi, Shizuoka 435-8558 (JP); NAKAMURA Shigeyuki, Hamamatsu-shi, Shizuoka 435-8558 (JP); OHTA Tsuyoshi, Hamamatsu-shi, Shizuoka 435-8558 (JP); MATSUMOTO Takuya, Hamamatsu-shi, Shizuoka 435-8558 (JP); FUJITA Takuya, Hamamatsu-shi, Shizuoka 435-8558 (JP)
(74) Representative: Boult Wade Tennant LLP
(86) International application number: PCT/JP2023/010956
(87) International publication number: WO 2023/233768

(57) **Abstract**

A radiation detector includes an optical semiconductor element including a plurality of light receiving regions, a scintillator unit disposed on the optical semiconductor element, and an adhesive layer disposed between the optical semiconductor element and the scintillator unit. The scintillator unit includes at least one scintillator corresponding to the plurality of light receiving regions. Each of the plurality of light receiving regions includes a plurality of light receiving units connected in parallel to each other. Each of the plurality of light receiving units includes an avalanche photodiode configured to operate in a Geiger mode and a quenching resistor connected in series to the avalanche photodiode. A distance between adjacent light receiving regions is greater than a distance between a light receiving region and a scintillator facing each other.

## Description

### Technical Field

The present disclosure relates to a radiation detector and a radiation detection device.

### Background Art

Patent Literature 1 discloses a radiation detector including a photoelectric conversion element, a filter disposed on the photoelectric conversion element, and a fluorescent element disposed on the filter. In the radiation detector disclosed in Patent Literature 1, when radiation is incident on the fluorescent element, the fluorescent element emits light, and only light in a short wavelength band in the emitted light passes through the filter and is incident on the photoelectric conversion element. The photoelectric conversion element detects the light in the short wavelength band.

### Citation List

### Patent Literature

Patent Literature 1: Japanese Unexamined Patent Publication No. H10-274675

### Summary of Invention

### Technical Problem

In the radiation detector described above, in some cases, an optical semiconductor element having a plurality of light receiving regions is used as the photoelectric conversion element, and a scintillator unit having at least one scintillator corresponding to the plurality of light receiving regions is used as the fluorescent element. In this case, there is a concern that light emitted from a certain region in the scintillator in response to the incidence of radiation will be incident not only on a light receiving region facing the region, but also on another light receiving region adjacent to the light receiving region, which results in a reduction in the accuracy of radiation detection.

An object of the present disclosure is to provide a radiation detector and a radiation detection device capable of detecting radiation with high accuracy.

### Solution to Problem

According to an aspect of the present disclosure, there is provided [1] "a radiation detector including: an optical semiconductor element including a plurality of light receiving regions; a scintillator unit disposed on the optical semiconductor element; and an adhesive layer disposed between the optical semiconductor element and the scintillator unit, in which the scintillator unit includes at least one scintillator corresponding to the plurality of light receiving regions, each of the plurality of light receiving regions includes a plurality of light receiving units connected in parallel to each other, each of the plurality of light receiving units includes an avalanche photodiode configured to operate in a Geiger mode and a quenching resistor connected in series to the avalanche photodiode, and a distance between adjacent light receiving regions among the plurality of light receiving regions is greater than a distance between a light receiving region and a scintillator facing each other among the plurality of light receiving regions and the at least one scintillator".

In the radiation detector, the distance between adjacent light receiving regions is greater than the distance between the light receiving region and the scintillator facing each other. Therefore, when light is emitted from a certain region in the scintillator in response to the incidence of radiation, the incidence of light on a light receiving region facing the region is promoted, and the incidence of light on a light receiving region adjacent to the light receiving region is suppressed. As a result, the radiation detector can detect radiation with high accuracy.

According to another aspect of the present disclosure, [2] "in the radiation detector according to [1], the adhesive layer may be in contact with each of the optical semiconductor element and the scintillator unit". According to this radiation detector, an interface between a plurality of layers is not present between the optical semiconductor element and the scintillator unit. Therefore, when light is emitted from a certain scintillator in response to the incidence of radiation, the incidence of light on a light receiving region facing the scintillator is further promoted, and the incidence of light on a light receiving region adjacent to the light receiving region is further suppressed.

According to still another aspect of the present disclosure, [3] "the radiation detector according to [1] may further include an optical filter layer disposed between the optical semiconductor element and the scintillator unit, in which the adhesive layer may be disposed between the optical filter layer and the scintillator unit, the optical filter layer may be in contact with each of the optical semiconductor element and the adhesive layer, and the adhesive layer may be in contact with each of the optical filter layer and the scintillator unit". According to this radiation detector, when light is emitted from a certain region in the scintillator in response to the incidence of radiation, the incidence of light in a desired wavelength band on a light receiving region facing the scintillator is promoted, and the incidence of light on a light receiving region adjacent to the light receiving region is suppressed.

According to yet another aspect of the present disclosure, [4] "in the radiation detector according to any one of [1] to [3], the distance between the adjacent light receiving regions may be equal to or greater than 0.1 mm". According to this radiation detector, when light is emitted from a certain region in the scintillator in response to the incidence of radiation, the incidence of light on a light receiving region adjacent to the light receiving region facing the region is further suppressed.

According to still yet another aspect of the present disclosure, [5] "in the radiation detector according to any one of [1] to [4], a width of each of the plurality of light receiving units may be equal to or less than 50 µm". According to this radiation detector, even when there is a deviation between the light receiving region and the scintillator facing each other, it is possible to suppress a reduction in energy resolution in radiation detection.

According to yet still another aspect of the present disclosure, [6] "the radiation detector according to any one of [1] to [5] may further include a wiring substrate, in which a plurality of optical semiconductor elements are mounted on the wiring substrate, and each of the plurality of optical semiconductor elements is the optical semiconductor element". According to this radiation detector, it is possible to expand a detection range of radiation while maintaining the size of the optical semiconductor element at an appropriate size.

According to still yet another aspect of the present disclosure, [7] "in the radiation detector according to [6], the plurality of optical semiconductor elements may be arranged in one direction, the plurality of light receiving regions may be arranged in the one direction in each of the plurality of optical semiconductor elements, the plurality of light receiving regions may include a pair of first light receiving regions located at both ends in the one direction and a plurality of second light receiving regions located between the pair of first light receiving regions, and a width of each of the pair of first light receiving regions may be smaller than a width of each of the plurality of second light receiving regions in the one direction". According to this radiation detector, in a case where the scintillator unit has a plurality of scintillators corresponding to the plurality of light receiving regions, even when the arrangement pitch of a plurality of optical semiconductor elements arranged in the one direction varies, the deviation of the scintillator from the light receiving region is absorbed by the first light receiving region. Therefore, in all of the optical semiconductor elements, it is possible to suppress an increase in the amount of deviation of the scintillator from the light receiving region.

According to yet still another aspect of the present disclosure, [8] "in the radiation detector according to [6] or [7], the plurality of optical semiconductor elements may be directly mounted on the wiring substrate". According to this radiation detector, it is possible to efficiently dissipate heat generated in each of the plurality of optical semiconductor elements to the wiring substrate and to reliably suppress a fluctuation in gain in each of the plurality of optical semiconductor elements or a variation in gain between the plurality of optical semiconductor elements.

According to still yet another aspect of the present disclosure, [9] "in the radiation detector according to [8], the plurality of optical semiconductor elements may be fixed onto a common pad included in the wiring substrate". According to this radiation detector, it is possible to efficiently dissipate heat generated in each of the plurality of optical semiconductor elements to the wiring substrate and to reliably suppress a fluctuation in gain in each of the plurality of optical semiconductor elements or a variation in gain between the plurality of optical semiconductor elements.

According to yet still another aspect of the present disclosure, [10] "in the radiation detector according to any one of [1] to [9], the at least one scintillator may be a plurality of scintillators corresponding to the plurality of light receiving regions". According to this radiation detector, when light is emitted from a certain scintillator in response to the incidence of radiation, the incidence of light on a light receiving region facing the scintillator is promoted, and the incidence of light on a light receiving region adjacent to the light receiving region is suppressed.

According to still yet another aspect of the present disclosure, [11] "in the radiation detector according to [10], the scintillator unit may further include a light reflecting member covering surfaces other than a surface on the optical semiconductor element side among surfaces of each of the plurality of scintillators ". According to this radiation detector, when light is emitted from a certain scintillator in response to the incidence of radiation, the incidence of light on a light receiving region facing the scintillator is promoted, and the incidence of light on a light receiving region adjacent to the light receiving region is suppressed.

According to yet still another aspect of the present disclosure, [12] there is provided "a radiation detection device including: the radiation detector according to any one of [1] to [11]; and a plurality of signal processing units corresponding to the plurality of light receiving regions, and configured to process a pulse signal output from each of the plurality of light receiving regions, in which each of the plurality of signal processing units includes a waveform shaping circuit, a plurality of comparators, and a plurality of counters, the waveform shaping circuit shapes a waveform of the pulse signal such that a pulse width is shortened, each of the plurality of comparators compares an intensity of the pulse signal input from the waveform shaping circuit with each of a plurality of different threshold values, and each of the plurality of counters counts the pulse signals having an intensity exceeding each of the plurality of threshold values for each of the plurality of threshold values".

According to the radiation detection device, it is possible to discriminate the energy of radiation for each of the plurality of light receiving regions.

According to still yet another aspect of the present disclosure, [13] "in the radiation detection device according to [12], each of the plurality of signal processing units may further include an anode potential correction circuit, and the anode potential correction circuit may correct an anode-side potential of each of the plurality of light receiving regions for each of the plurality of light receiving regions". According to this radiation detection device, it is possible to adjust gain for each of the plurality of light receiving regions.

According to yet still another aspect of the present disclosure, [14] "the radiation detection device according to [12] or [13] may further include a cathode potential correction circuit corresponding to the plurality of light receiving regions, in which the cathode potential correction circuit may collectively correct a cathode-side potential of each of the plurality of light receiving regions according to a signal output from a temperature sensor further included in the radiation detector". According to this radiation detection device, it is possible to suppress a fluctuation in the gain of the plurality of light receiving regions caused by the temperature of the optical semiconductor element.

According to still yet another aspect of the present disclosure, [15] "the radiation detection device according to any one of [12] to [14] may further include a threshold value linearity correction circuit corresponding to the plurality of light receiving regions, in which the threshold value linearity correction circuit may correct each of the plurality of threshold values such that each of the plurality of threshold values is the same between the plurality of light receiving regions". According to this radiation detection device, it is possible to suppress a variation in the threshold value input to each of the plurality of comparators corresponding to each other between the plurality of light receiving regions.

### Advantageous Effects of Invention

According to the present disclosure, it is possible to provide a radiation detector and a radiation detection device capable of detecting radiation with high accuracy.

### Brief Description of Drawings

[FIG. 1] FIG. 1 is a plan view illustrating a radiation detector according to an embodiment.
[FIG. 2] FIG. 2 is a plan view illustrating a portion of the radiation detector illustrated in FIG. 1.
[FIG. 3] FIG. 3 is a cross-sectional view illustrating the radiation detector taken along a line III-III illustrated in FIG. 1.
[FIG. 4] FIG. 4 is a view illustrating a positional relationship of a light receiving region and a scintillator illustrated in FIG. 1.
[FIG. 5] FIG. 5 is a cross-sectional view illustrating a portion of an optical semiconductor element illustrated in FIG. 1.
[FIG. 6] FIG. 6 is a circuit diagram illustrating the optical semiconductor element illustrated in FIG. 1.
[FIG. 7] FIG. 7 is a cross-sectional view illustrating a portion of an optical semiconductor element according to a modification example.
[FIG. 8] FIG. 8 is a graph illustrating a relationship between an amount of deviation of the scintillator from the light receiving region and an energy resolution statistical limit.
[FIG. 9] FIG. 9 is a cross-sectional view illustrating a portion of the radiation detector illustrated in FIG. 3.
[FIG. 10] FIG. 10 is a graph illustrating a relationship between radiation energy and leakage light for an example and a comparative example.
[FIG. 11] FIG. 11 is a graph illustrating energy resolution for the example and the comparative example.
[FIG. 12] FIG. 12 is a graph illustrating a normalized output for the example and the comparative example.
[FIG. 13] FIG. 13 is a graph illustrating a relationship between a radiation dose rate and a fluctuation in gain for the example and the comparative example.
[FIG. 14] FIG. 14 is a block diagram illustrating a radiation detection device according to an embodiment.
[FIG. 15] FIG. 15 is a cross-sectional view illustrating a portion of a radiation detector according to a modification example.
[FIG. 16] FIG. 16 is a plan view illustrating an optical semiconductor element of the radiation detector according to the modification example.
[FIG. 17] FIG. 17 is a plan view illustrating the radiation detector according to the modification example.
[FIG. 18] FIG. 18 is an exploded perspective view illustrating a radiation detector according to a modification example.
[FIG. 19] FIG. 19 is an exploded perspective view illustrating a radiation detector according to a modification example.

### Description of Embodiments

Hereinafter, embodiments of the present disclosure will be described in detail with reference to the drawings. In addition, in each drawing, the same or corresponding portions are denoted by the same reference numerals, and a duplicated description will be omitted.

### [Configuration of Radiation Detector]

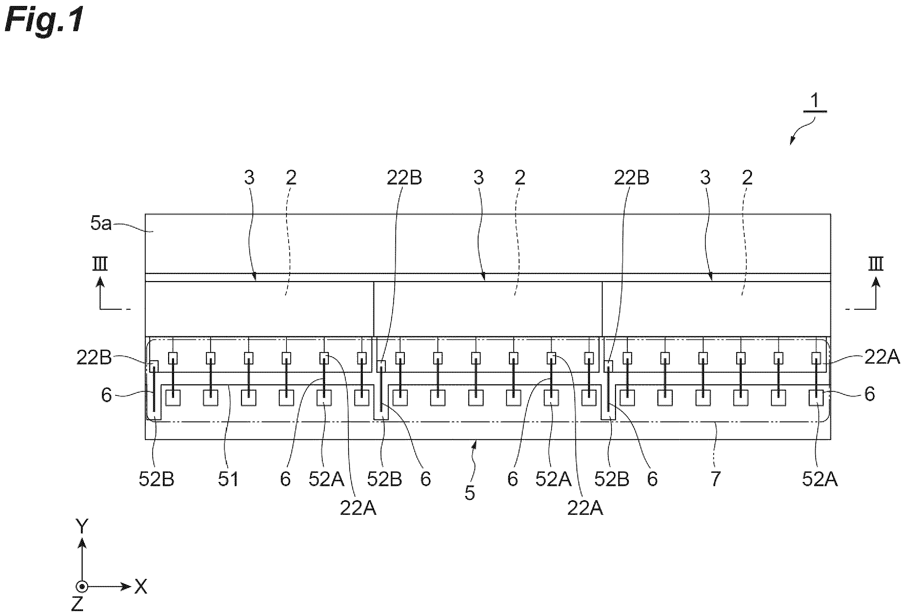

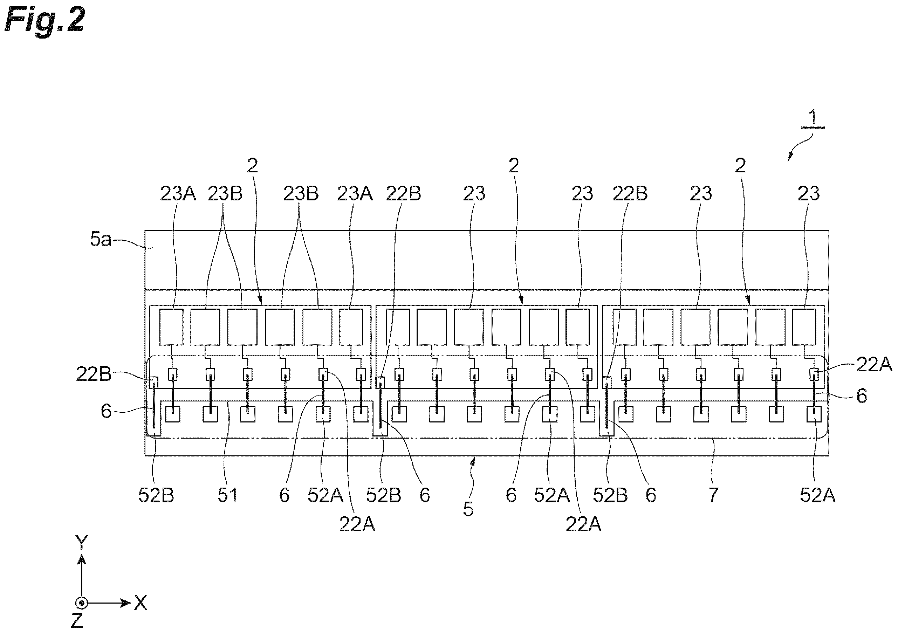

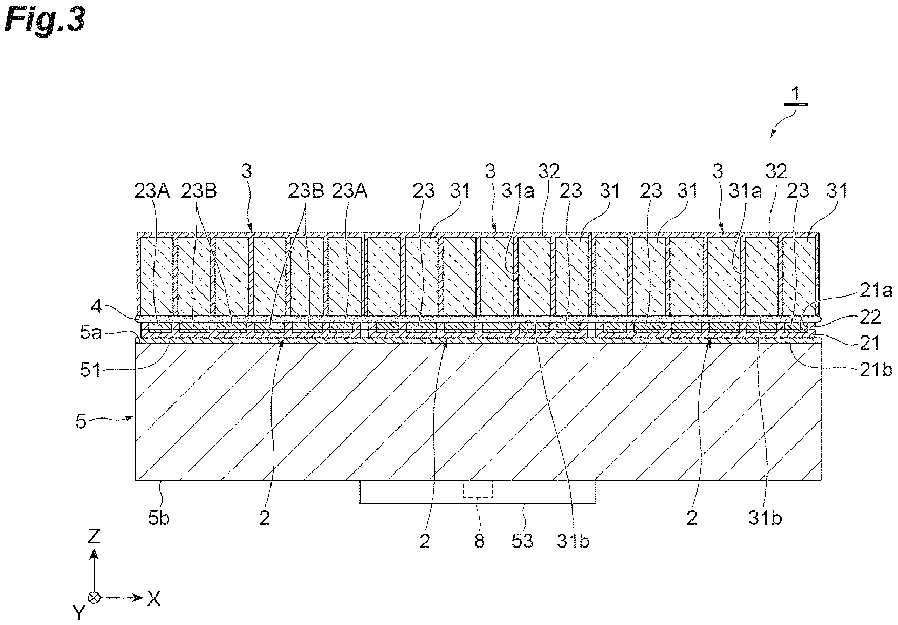

As illustrated in FIGS. 1, 2, and 3, a radiation detector 1 includes a plurality of optical semiconductor elements 2, a plurality of scintillator units 3, an adhesive layer 4, a wiring substrate 5, a plurality of wires 6, a protective resin member 7, and a temperature sensor 8. In the following description, a thickness direction of the wiring substrate 5 is referred to as a Z direction, a direction parallel to the Z direction is referred to as an X direction, and a direction perpendicular to both the Z direction and the X direction is referred to as a Y direction. Further, in FIGS. 1 and 2, the protective resin member 7 is represented by a two-dot chain line. Furthermore, in FIG. 2, the illustration of the plurality of scintillator units 3 is omitted.

The wiring substrate 5 has a front surface 5a and a rear surface 5b. When viewed from the Z direction, the wiring substrate 5 has, for example, a rectangular shape in which a long side direction is the X direction and a short side direction is the Y direction. A mounting pad (pad) 51 is provided on the front surface 5a of the wiring substrate 5. The mounting pad 51 has, for example, a predetermined width in the Y direction and extends in the X direction across the front surface 5a. The plurality of optical semiconductor elements 2 are fixed on the common mounting pad 51 of the wiring substrate 5 by, for example, die bonding while being arranged in a row in the X direction (one direction). That is, the plurality of optical semiconductor elements 2 are directly mounted on the wiring substrate 5. The temperature sensor 8 is a sensor for measuring the temperature of the plurality of optical semiconductor elements 2 and is mounted on the rear surface 5b of the wiring substrate 5.

Each optical semiconductor element 2 has a semiconductor layer 21 and a wiring layer 22. The semiconductor layer 21 has a front surface 21a and a rear surface 21b. The wiring layer 22 is formed on the front surface 21a of the semiconductor layer 21. In this embodiment, the rear surface 21b of the semiconductor layer 21 is fixed to the mounting pad 51. When viewed from the Z direction, each optical semiconductor element 2 has, for example, a rectangular shape in which a long side direction is the X direction and a short side direction is the Y direction. In each optical semiconductor element 2, the semiconductor layer 21 and the wiring layer 22 constitute a plurality of light receiving regions 23. That is, each optical semiconductor element 2 has a plurality of light receiving regions 23. In each optical semiconductor element 2, the plurality of light receiving regions 23 are arranged in a row in the X direction.

In the X direction, the width of each of a pair of light receiving regions (first light receiving regions) 23A is smaller than the width of each of a plurality of light receiving regions (second light receiving regions) 23B. The pair of light receiving regions 23A are a pair of light receiving regions located at both ends in the X direction among the plurality of light receiving regions 23 of each optical semiconductor element 2. The plurality of light receiving regions 23B are a plurality of light receiving regions located between the pair of light receiving regions 23A among the plurality of light receiving regions 23 of each optical semiconductor element 2. When viewed from the Z direction, each light receiving region 23A has, for example, a rectangular shape in which a long side direction is the Y direction and a short side direction is the X direction. Each light receiving region 23B has, for example, a square shape when viewed from the Z direction. The length of one side of each light receiving region 23B is, for example, about 1 mm. A distance between adjacent light receiving regions 23 is, for example, about 0.2 mm.

In each optical semiconductor element 2, a plurality of anode electrode pads 22A and a cathode electrode pad 22B are provided on a surface of the wiring layer 22 opposite to the semiconductor layer 21. Each anode electrode pad 22A is located on one side in the Y direction with respect to each light receiving region 23. The cathode electrode pad 22B is located on one side in the X direction with respect to the plurality of anode electrode pads 22A. One anode electrode pad 22A corresponds to one light receiving region 23 and is electrically connected to the anode side of one light receiving region 23 (which will be described in detail below). The cathode electrode pad 22B corresponds to the plurality of light receiving regions 23 and is electrically connected to the cathode sides of the plurality of light receiving regions 23 (which will be described in detail below). Each of the electrode pads 22A and 22B is spaced from each light receiving region 23 by, for example, 1 mm or more in the Y direction.

A plurality of individual electrode pads 52A and a plurality of common electrode pads 52B are provided on the front surface 5a of the wiring substrate 5. Each individual electrode pad 52A is located on one side in the Y direction with respect to each anode electrode pad 22A. Each common electrode pad 52B is located on one side in the Y direction with respect to each cathode electrode pad 22B. The plurality of common electrode pads 52B are formed integrally (continuously) with the mounting pad 51. The wire 6 is hung between the anode electrode pad 22A and the individual electrode pad 52A corresponding to each other. Similarly, the wire 6 is hung between the cathode electrode pad 22B and the common electrode pad 52B corresponding to each other.

The plurality of electrode pads 22A, 22B, 52A, and 52B and the wires 6 are covered with the protective resin member 7. As described above, in the radiation detector 1, each of the electrode pads 22A and 22B is spaced from each light receiving regions 23 by, for example, 1 mm or more in the Y direction. Therefore, the protective resin member 7 is prevented from reaching each light receiving region 23 during the manufacture of the radiation detector 1.

A connector 53 is provided on the rear surface 5b of the wiring substrate 5. The connector 53 is an input/output port for electrical signals in the wiring substrate 5. In the radiation detector 1, the input and output of electrical signals to and from each optical semiconductor element 2 and the input and output of electrical signals to and from the temperature sensor 8 are performed through the connector 53.

The plurality of scintillator units 3 are arranged in a row in the X direction. The plurality of scintillator units 3 correspond to the plurality of optical semiconductor elements 2. Specifically, each scintillator unit 3 is disposed over each optical semiconductor element 2 with the adhesive layer 4 interposed therebetween. The adhesive layer 4 is disposed between the plurality of optical semiconductor elements 2 and the plurality of scintillator units 3. The adhesive layer 4 is in contact with each of the plurality of optical semiconductor elements 2 and the plurality of scintillator units 3. A material forming the adhesive layer 4 is, for example, a silicone adhesive, an epoxy adhesive, or the like. The thickness of the adhesive layer 4 is, for example, less than 100 µm (typically, about 20 to 30 µm).

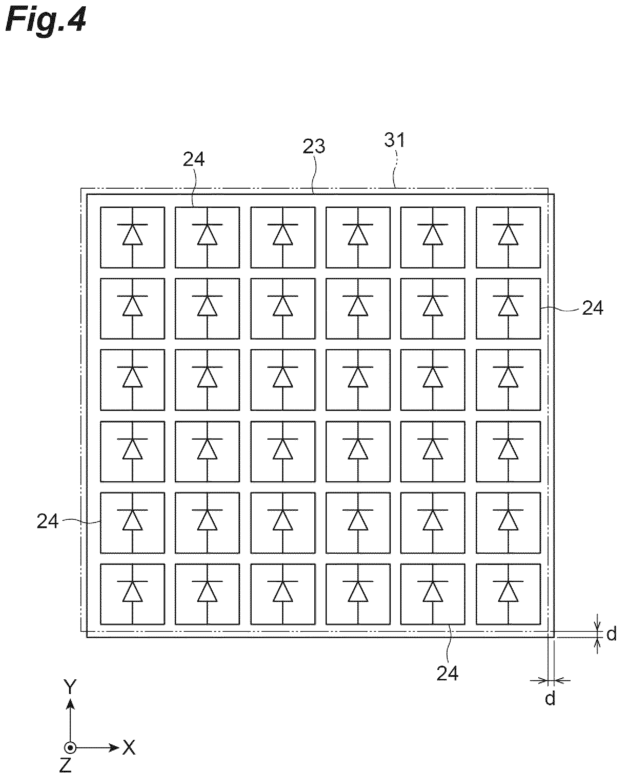

Each scintillator unit 3 has a plurality of scintillators 31 and a light reflecting member 32. In each scintillator unit 3, the plurality of scintillators 31 are arranged in a row in the X direction. The plurality of scintillators 31 correspond to the plurality of light receiving regions 23. Specifically, each scintillator 31 is disposed over each light receiving region 23 with the adhesive layer 4 interposed therebetween. Each scintillator 31 has, for example, a rectangular parallelepiped shape in which a longitudinal direction is the Z direction. The cross-sectional shape of each scintillator 31 perpendicular to the Z direction is substantially the same as the shape of each light receiving region 23B when viewed from the Z direction (see FIG. 4) and is, for example, a square shape. A material forming each scintillator 31 is, for example, LYSO:Ce, YAP:Ce, LuAG:Pr, or the like. The width of each scintillator 31 in each of the X direction and the Y direction is, for example, about 1 mm. The height of each scintillator 31 in the Z direction is, for example, about several millimeters.

In each scintillator unit 3, the light reflecting member 32 covers surfaces other than a surface 31b facing the optical semiconductor element 2 among surfaces 31a of each scintillator 31. When radiation (for example, X-rays, γ-rays, or the like) is incident on a certain scintillator 31 and light is emitted from the scintillator 31, the light travels toward the surface 31b or is reflected by the light reflecting member 32 to be emitted from the surface 31b. A material forming the light reflecting member 32 is, for example, titanium oxide or the like. The thickness of the light reflecting member 32 (corresponding to the distance between adjacent scintillators 31) is, for example, about 0.2 mm.

### [Configuration of Optical Semiconductor Element]

As described above, each optical semiconductor element 2 has a plurality of light receiving regions 23. As illustrated in FIG. 4, the light receiving region 23 has a plurality of light receiving units 24. The plurality of light receiving units 24 are arranged two-dimensionally along a plane perpendicular to the Z direction. In this embodiment, the plurality of light receiving units 24 are arranged in a matrix with the X direction as a row direction and the Y direction as a column direction. Each light receiving unit 24 is a single photon avalanche diode (SPAD), and the optical semiconductor element 2 is a silicon photomultiplier (SiPM) in which one channel is configured by one light receiving region 23.

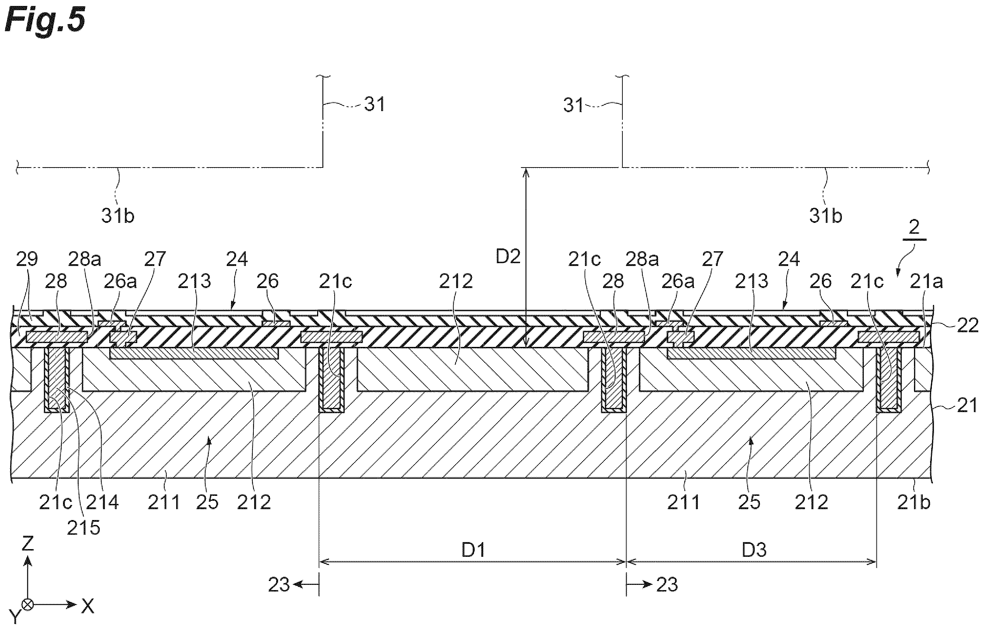

As illustrated in FIG. 5, the semiconductor layer 21 includes an N-type semiconductor region 211, a P-type semiconductor region 212, and a P⁺-type semiconductor region 213 for each light receiving unit 24. The N-type semiconductor region 211 extends across a plurality of light receiving units 24. The P-type semiconductor region 212 is formed in the N-type semiconductor region 211 along the front surface 21a of the semiconductor layer 21 and forms a PN junction with the N-type semiconductor region 211. The P⁺-type semiconductor region 213 is formed in the P-type semiconductor region 212 along the front surface 21a of the semiconductor layer 21. In each light receiving unit 24, an avalanche photodiode (APD) 25 is configured by the N-type semiconductor region 211, the P-type semiconductor region 212, and the P⁺-type semiconductor region 213. A material forming the semiconductor layer 21 is, for example, silicon. In the semiconductor layer 21, P-type impurities are, for example, Group 3 elements, such as B, and N-type impurities are, for example, Group 5 elements such as N, P, and As.

The semiconductor layer 21 has a trench 21c. The trench 21c extends to separate the P-type semiconductor regions 212 from each other. The trench 21c opens to the front surface 21a of the semiconductor layer 21. The depth of the trench 21c from the front surface 21a is greater than the depth of the P-type semiconductor region 212 from the front surface 21a. In each light receiving unit 24, a portion of the N-type semiconductor region 211 is disposed between the P-type semiconductor region 212 and the trench 21c. An insulating region 214 is formed along an inner surface of the trench 21c. A material forming the insulating region 214 is, for example, SiO₂. A metal member 215 is disposed in the trench 21c. A material forming the metal member 215 is, for example, W. The width of the trench 21c is, for example, about 0.5 µm. The depth of the trench 21c is, for example, about several micrometers.

The wiring layer 22 has a plurality of quenching resistors 26, a plurality of through electrodes 27, a readout wire 28, and an insulating layer 29 for each light receiving region 23. The insulating layer 29 is composed of a plurality of insulating films and extends across a plurality of light receiving regions 23. A material forming each insulating film is, for example, SiO₂ or SiN. The plurality of quenching resistors 26, the plurality of through electrodes 27, and the readout wire 28 are formed in the insulating layer 29.

One quenching resistor 26 constitutes one light receiving unit 24 together with one APD 25. In each light receiving unit 24, the quenching resistor 26 extends along an outer edge of the P⁺-type semiconductor region 213 when viewed from the Z direction. One end 26a of the quenching resistor 26 is electrically connected to the P⁺-type semiconductor region 213 via the through electrode 27. The other end (not illustrated) of the quenching resistor 26 is electrically connected to the readout wire 28. A material forming the quenching resistor 26 is, for example, SiCr. A material forming the through electrode 27 is, for example, Al.

The readout wire 28 has a plurality of openings 28a. In each light receiving unit 24, the opening 28a includes each P⁺-type semiconductor region 213 and the quenching resistor 26 when viewed from the Z direction. In each light receiving region 23, the readout wire 28 extends across a plurality of light receiving units 24. The readout wire 28 is electrically connected to the corresponding anode electrode pad 22A (see FIG. 2). A material forming the readout wire 28 is, for example, Al. In addition, the N-type semiconductor region 211 extending across the plurality of light receiving units 24 in each light receiving region 23 is electrically connected to the cathode electrode pad 22B (see FIG. 2) via the through electrode (not illustrated) or the like.

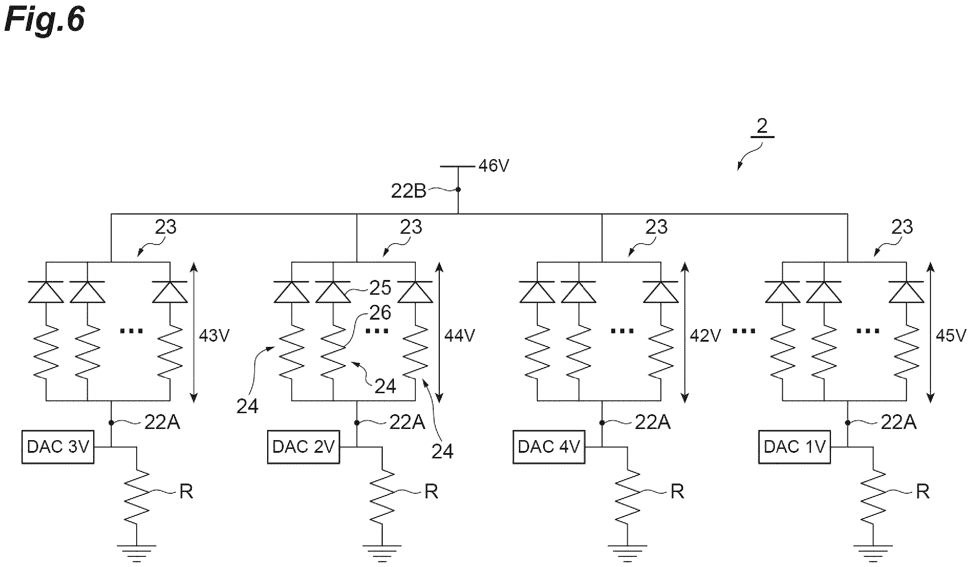

FIG. 6 is a circuit diagram illustrating the optical semiconductor element 2. As illustrated in FIG. 6, each light receiving region 23 has a plurality of light receiving units 24 connected in parallel. Each light receiving unit 24 includes the APD 25 and the quenching resistor 26 connected in series to the APD 25. In each light receiving region 23, an anode of each APD 25 is electrically connected to the anode electrode pad 22A via each quenching resistor 26, and a cathode of each APD 25 is electrically connected to the cathode electrode pad 22B. Further, a "DAC" illustrated in FIG. 6 will be described below.

In the optical semiconductor element 2, each APD 25 operates in the Geiger mode. In the Geiger mode, a reverse voltage (reverse bias voltage) higher than a breakdown voltage of the APD 25 is applied to each APD 25. As an example, when each anode electrode pad 22A is grounded through a resistor R, a positive voltage higher than the breakdown voltage of the APD 25 is applied to the cathode electrode pad 22B.

When light is incident on any and at least one APD 25 in a state in which each APD 25 is operating in the Geiger mode, charge is generated in the APD 25 by photoelectric conversion, and the generated charge is amplified by avalanche multiplication. The charge amplified in the APD 25 is output to the anode electrode pad 22A through the corresponding quenching resistor 26 and is output as a pulse signal from the anode electrode pad 22A to an external signal processing unit.

### [Dimensions Related to Light Receiving Region and Scintillator]

As illustrated in FIG. 5, a distance D1 between adjacent light receiving regions 23 among the plurality of light receiving regions 23 is greater than a distance D2 between the light receiving region 23 and the scintillator 31 facing each other among the plurality of light receiving regions 23 and the plurality of scintillators 31. In this embodiment, the distance D1 between adjacent light receiving regions 23 is equal to or greater than 0.1 mm, and the distance D2 between the light receiving region 23 and the scintillator 31 facing each other is less than 0.1 mm. In this embodiment, a width D3 of each light receiving unit 24 is equal to or less than 50 µm.

The distance D1 between adjacent light receiving regions 23 means the shortest distance between "an inner edge of a separation region (in this embodiment, a region configured by the trench 21c and the insulating region 214) extending along the outer edge of one light receiving region 23 when viewed from the Z direction" and "an inner edge of a separation region (in this embodiment, a region configured by the trench 21c and the insulating region 214) extending along the outer edge of the other light receiving region 23 when viewed from the Z direction" with a focus on adjacent light receiving regions 23. The distance D2 between the light receiving region 23 and the scintillator 31 facing each other means the shortest distance between the "surface (in this embodiment, the front surface 21a) facing the scintillator 31 in the semiconductor layer 21 in which the plurality of APDs 25 are formed" and the "surface (in this embodiment, the surface 31b) facing the semiconductor layer 21 in the scintillator 31". The width D3 of the light receiving unit 24 is the width of a portion defined by the inner edge of the separation region (in this embodiment, the region configured by the trench 21c and the insulating region 214) when viewed from the Z direction and means the width of the portion in each of the X direction and the Y direction.

Here, the separation region is a region suppressing the outward spreading of a depletion layer 20 in the APDs 25 arranged along the outer edge of each light receiving region 23. In this embodiment, the separation region is a region configured by the trench 21c and the insulating region 214. As an example, the separation region may be a region configured by an N⁺-type semiconductor region surrounding the P-type semiconductor region 212 in each APD 25 when viewed from the Z direction.

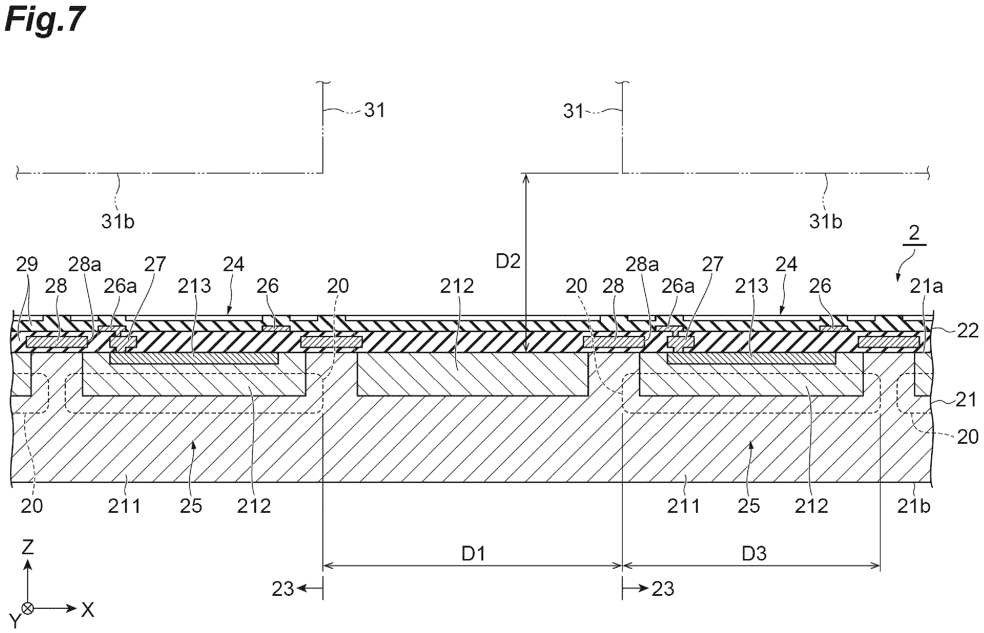

In addition, the distance D1 when the separation region is not provided means the shortest distance between "an outer edge of the depletion layer 20 when the depletion layer 20 spreads to its maximum in the APDs 25 arranged along the outer edge of one light receiving region 23" and "an outer edge of the depletion layer 20 when the depletion layer 20 spreads to its maximum in the APDs 25 arranged along the outer edge of the other light receiving region 23" with a focus on adjacent light receiving regions 23 as illustrated in FIG. 7. The width D3 of the light receiving unit 24 when the separation region is not provided is the width of the depletion layer 20 when the depletion layer 20 expands to its maximum in the APD 25 and means the width of the depletion layer 20 in each of the X direction and the Y direction. Alternatively, the width D3 of the light receiving unit 24 when the separation region is not provided means the distance between the centers of adjacent P⁺-type semiconductor regions 213 in one light receiving region 23 (the distance between the centers when viewed from the Z direction).

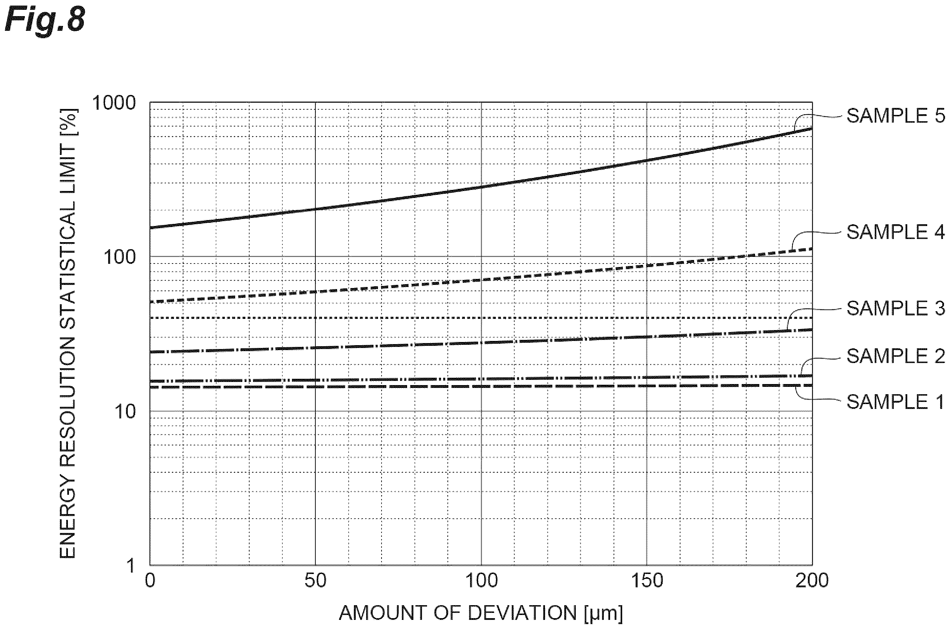

FIG. 8 is a graph illustrating a relationship between the amount of deviation of the scintillator 31 from the light receiving region 23 and an energy resolution statistical limit. In this simulation, samples 1 to 5 were prepared. In samples 1 to 5, the shape of the light receiving region 23 when viewed from the Z direction was a square shape of 1 mm × 1 mm and the cross-sectional shape of the scintillator 31 perpendicular to the Z direction was a square shape of 1 mm × 1 mm. Based on this premise, the shape of the light receiving unit 24 when viewed from the Z direction was a square shape of 15 × 15 µm in sample 1. In sample 2, the shape of the light receiving unit 24 when viewed from the Z direction was a square shape of 25 × 25 µm. In sample 3, the shape of the light receiving unit 24 when viewed from the Z direction was a square shape of 50 × 50 µm. In sample 4, the shape of the light receiving unit 24 when viewed from the Z direction was a square shape of 75 × 75 µm. In sample 5, the shape of the light receiving unit 24 when viewed from the Z direction was a square shape of 100 × 100 µm. In samples 1 to 5, the distance between adjacent light receiving units 24 was the same.

As illustrated in FIG. 4, an amount of deviation d of the scintillator 31 from the light receiving region 23 was changed while being kept equal in the X direction and the Y direction, and the energy resolution statistical limit was calculated for each amount of deviation in each of samples 1 to 5. In this case, the amount of incident light was set to 960 photons, and photon detection efficiency was set to 50%. In general, an energy resolution of 40% or less is required to achieve the energy discrimination of radiation. Further, in general, the amount of deviation of the scintillator 31 from the light receiving region 23 is about several tens of micrometers to 100 µm. As illustrated in FIG. 8, in samples 1 to 3, the energy resolution statistical limit was equal to or less than 40% when the amount of deviation was in the range of several tens of micrometers to 100 µm. As can be seen from the simulation results, it is preferable that the width D3 of each light receiving unit 24 is equal to or less than 50 µm.

### [Operation and Effect of Radiation Detector]

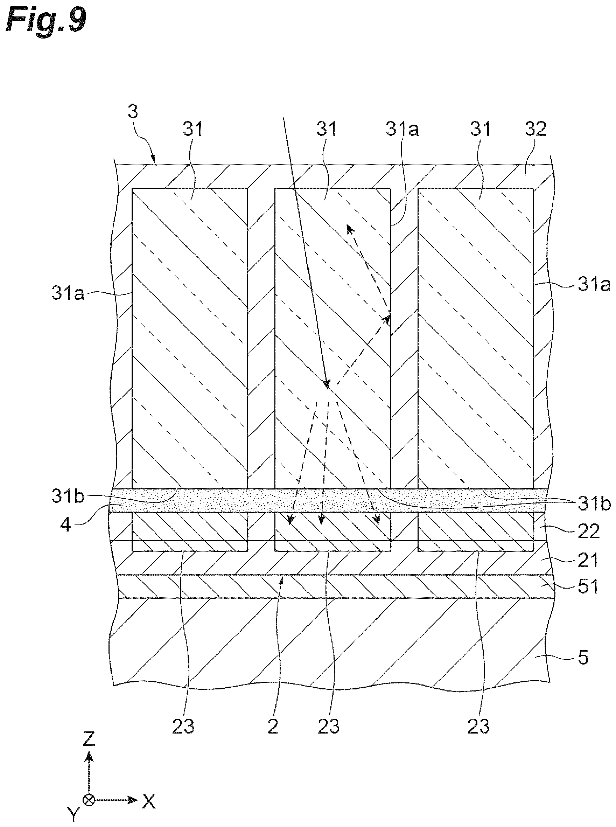

In the radiation detector 1, the distance D1 between adjacent light receiving regions 23 is greater than the distance D2 between the light receiving region 23 and the scintillator 31 facing each other. Therefore, as illustrated in FIG. 9, when light (a dashed line in FIG. 9) is emitted from a certain scintillator 31 in response to the incidence of radiation (a solid line in FIG. 9), the incidence of light on a light receiving region 23 facing the scintillator 31 is promoted, and the incidence of light on a light receiving region 23 adjacent to the light receiving region 23 is suppressed. As a result, the radiation detector 1 can detect radiation with high accuracy.

In the radiation detector 1, the adhesive layer 4 disposed between the plurality of optical semiconductor elements 2 and the plurality of scintillator units 3 is in contact with each of the plurality of optical semiconductor elements 2 and the plurality of scintillator units 3. Therefore, since an interface between a plurality of layers is not present between the optical semiconductor element 2 and the scintillator unit 3 corresponding to each other, when light is emitted from a certain scintillator 31 in response to the incidence of radiation, the incidence of light on a light receiving region 23 facing the scintillator 31 is further promoted, and the incidence of light on a light receiving region 23 adjacent to the light receiving region 23 is further suppressed.

In the radiation detector 1, the distance D1 between adjacent light receiving regions 23 is equal to or greater than 0.1 mm. Therefore, when light is emitted from a certain scintillator 31 in response to the incidence of radiation, the incidence of light on a light receiving region 23 adjacent to the light receiving region 23 facing the scintillator 31 is further suppressed.

In the radiation detector 1, the width D3 of each light receiving unit 24 is equal to or less than 50 µm. Therefore, for example, even when there is a deviation between the light receiving region 23 and the scintillator 31 facing each other, it is possible to suppress a reduction in energy resolution in radiation detection.

In the radiation detector 1, a plurality of optical semiconductor elements 2 are mounted on the wiring substrate 5. Therefore, it is possible to expand the detection range of radiation while maintaining the size of each optical semiconductor element 2 at an appropriate size.

In the radiation detector 1, a plurality of optical semiconductor elements 2 are arranged in the X direction, and a plurality of light receiving regions 23 are arranged in the X direction in each optical semiconductor element 2. Furthermore, the width of each of a pair of light receiving regions 23A located at both ends in the X direction among the plurality of light receiving regions 23 is smaller than the width of each of a plurality of light receiving regions 23B located between the pair of light receiving regions 23A among the plurality of light receiving regions 23. Therefore, even when the arrangement pitch of a plurality of optical semiconductor elements 2 arranged in the X direction varies, the deviation of the scintillator 31 from the light receiving region 23 is absorbed by the light receiving region 23A. As a result, in all of the optical semiconductor elements 2, it is possible to suppress an increase in the amount of deviation of the scintillator 31 from the light receiving region 23.

In the radiation detector 1, a plurality of optical semiconductor elements 2 are directly mounted on the wiring substrate 5. Therefore, it is possible to efficiently dissipate heat generated in each optical semiconductor element 2 to the wiring substrate 5 and to reliably suppress a fluctuation in gain (multiplication factor) in each optical semiconductor element 2 or a variation in gain between a plurality of optical semiconductor elements 2.

In the radiation detector 1, a plurality of optical semiconductor elements 2 are fixed onto the common mounting pad 51 of the wiring substrate 5. Therefore, it is possible to efficiently dissipate the heat generated in each optical semiconductor element 2 to the wiring substrate 5 and to reliably suppress a fluctuation in gain in each optical semiconductor element 2 or a variation in gain between a plurality of optical semiconductor elements 2.

The effect will be further described using examples and comparative examples. As a radiation detector according to an example, a radiation detector was prepared in which only the adhesive layer 4 was disposed between a plurality of optical semiconductor elements 2 and a plurality of scintillator units 3 and the distance D1 between adjacent light receiving regions 23 was greater than the distance D2 between the light receiving region 23 and the scintillator 31 facing each other, similarly to the above-described radiation detector 1. As a radiation detector according to a comparative example, a radiation detector was prepared in which a plurality of optical semiconductor elements 2 were accommodated in a package, the adhesive layer 4 and a protective glass member were disposed between the plurality of optical semiconductor elements 2 and a plurality of scintillator units 3, and the distance D2 between the light receiving region 23 and the scintillator 31 facing each other was greater than the distance D1 between adjacent light receiving regions 23.

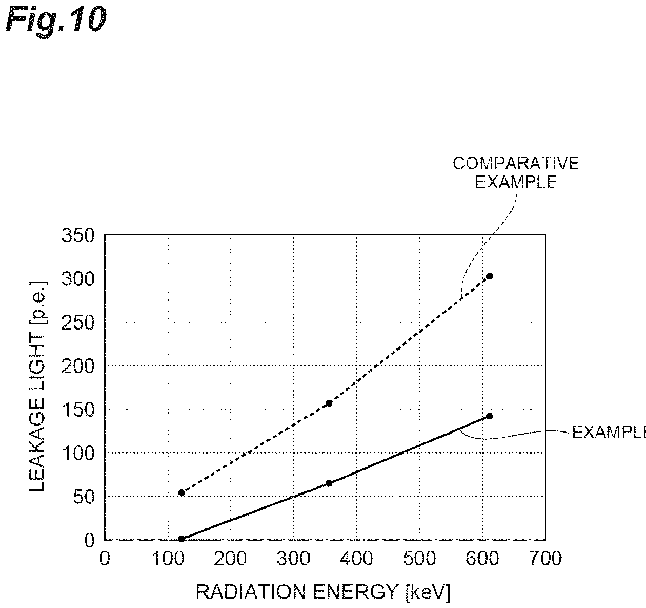

FIG. 10 is a graph illustrating the relationship between radiation energy and leakage light for the example and the comparative example. In each of the radiation detector according to the example and the radiation detector according to the comparative example, γ-rays were incident on a predetermined scintillator 31, and the amount of signal (p.e.: photoelectron) in a light receiving region 23 adjacent to the light receiving region 23 facing the scintillator 31 was measured as the leakage light. As a result, as illustrated in FIG. 10, in the radiation detector according to the example, there was almost no leakage light for γ-rays of 120 keV. In the radiation detector according to the example, even for γ-rays of 300 keV or more, the leakage light was suppressed to about 40% as compared to the radiation detector according to the comparative example.

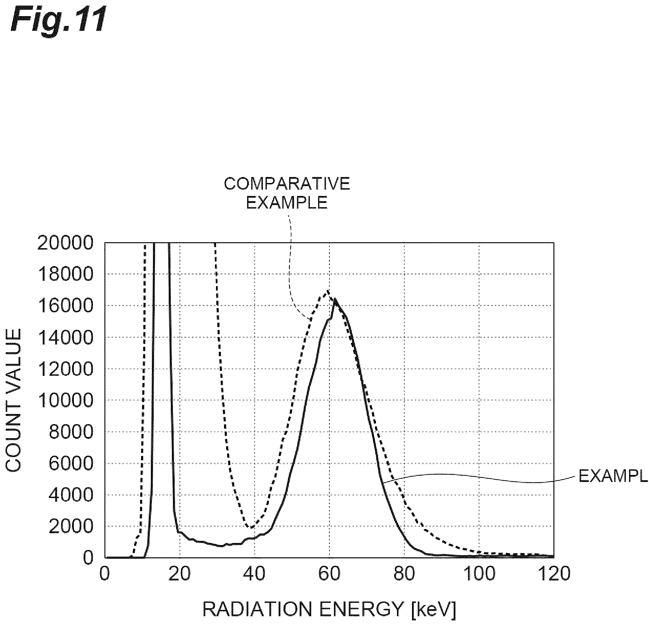

FIG. 11 is a graph illustrating energy resolution for the example and the comparative example. In each of the radiation detector according to the example and the radiation detector according to the comparative example, γ-rays were incident on a predetermined scintillator 31, and a count value in a light receiving region 23 facing the scintillator 31 was measured. As a result, as illustrated in FIG. 11, while the energy resolution was 41.5% for γ-rays of 59.5 keV in the radiation detector according to the comparative example, the energy resolution was 31.8% for γ-rays of 59.5 keV in the radiation detector according to the example. Therefore, it was confirmed that, in the radiation detector according to the example, the energy resolution was improved as compared to the radiation detector according to the comparative example.

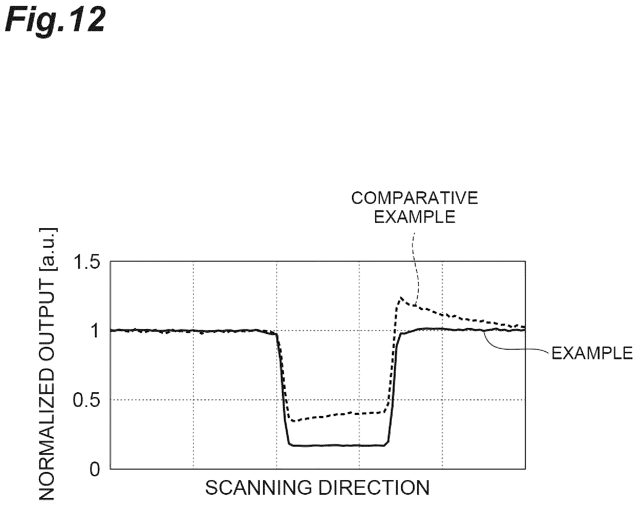

FIG. 12 is a graph illustrating a normalized output for the example and the comparative example. In each of the radiation detector according to the example and the radiation detector according to the comparative example, an object having a predetermined length was moved in a scanning direction while being irradiated with X-rays, and an output in a predetermined light receiving region 23 was measured. As a result, as illustrated in FIG. 12, in the radiation detector according to the comparative example, the output immediately after the X-rays passed through the object temporarily increased as compared to the output before the X-rays passed through the object and then gradually decreased to the same level as the output before the X-rays passed through the object. This means that the temperature of the optical semiconductor element 2 decreases and the gain of the light receiving region 23 increases while the X-rays are passing through the object, and the temperature of the optical semiconductor element 2 gradually increases and the gain of the light receiving region 23 gradually decreases after the X-rays pass through the object. In contrast, in the radiation detector according to the example, the output was the same before and after the X-rays pass through the object. This means that the heat generated in the optical semiconductor element 2 is efficiently dissipated such that the temperature of the optical semiconductor element 2 remains substantially constant and a fluctuation in gain is suppressed.

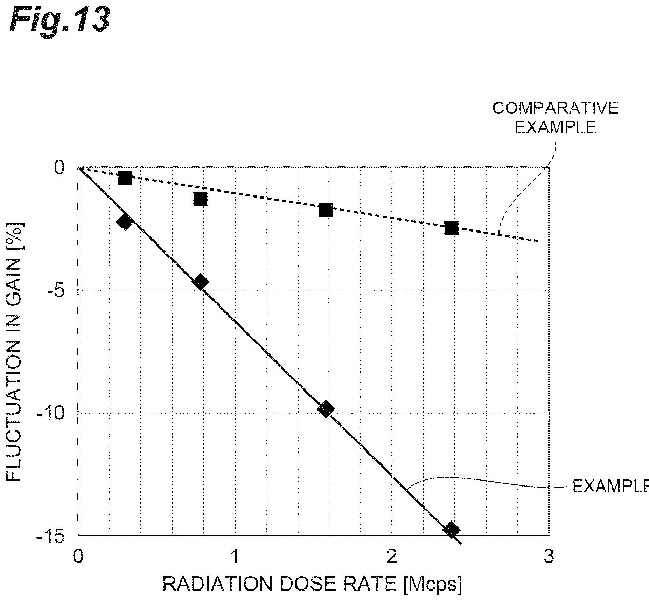

FIG. 13 is a graph illustrating a relationship between a radiation dose rate and a fluctuation in gain for the example and the comparative example. In each of the radiation detector according to the example and the radiation detector according to the comparative example, in a state in which X-rays were emitted, the output in a predetermined light receiving region 23 was measured. As a result, as illustrated in FIG. 13, it was confirmed that, in the radiation detector according to the embodiment, temperature stability was improved by about six times as compared to the radiation detector according to the comparative example.

### [Radiation Detection Device]

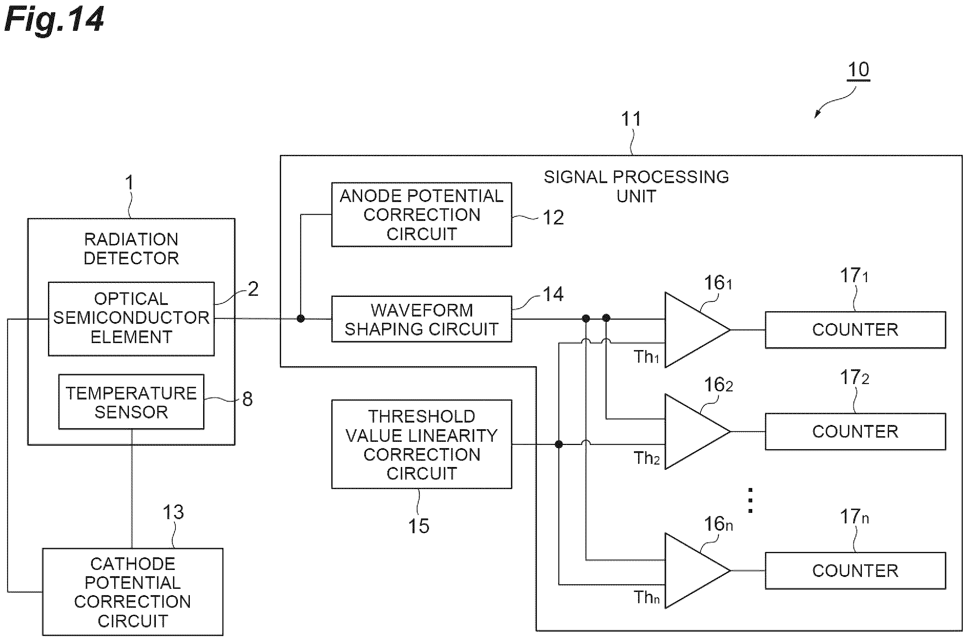

FIG. 14 is a block diagram illustrating a radiation detection device 10 including the radiation detector 1. As illustrated in FIG. 14, the radiation detection device 10 includes the radiation detector 1, a plurality of signal processing units 11, a threshold value linearity correction circuit 15, and a cathode potential correction circuit 13. In addition, for the plurality of signal processing units 11, only one signal processing unit 11 is illustrated in FIG. 10.

The plurality of signal processing units 11 correspond to a plurality of light receiving regions 23 for each optical semiconductor element 2. That is, one signal processing unit 11 is provided for one light receiving region 23. Each signal processing unit 11 processes a pulse signal output from the corresponding light receiving region 23. As an example, the plurality of signal processing units 11 are physically configured by a single integrated circuit.

Each signal processing unit 11 includes an anode potential correction circuit 12, a waveform shaping circuit 14, n comparators 16₁ to 16ₙ (n is an integer equal to or greater than 2), and n counters 17₁ to 17ₙ. The waveform shaping circuit 14 shapes the waveform of the pulse signal output from the light receiving region 23. Specifically, the waveform shaping circuit 14 shapes the waveform of the pulse signal such that a pulse width is shortened. Each of the comparators 16₁ to 16ₙ compares the intensity of the pulse signal input from the waveform shaping circuit 14 with each of threshold values Th₁ to Thₙ input from the threshold value linearity correction circuit 15. Each of the threshold values Th₁ to Thₙ is a threshold value for the intensity of the pulse signal and increases stepwise from Th₁ to Thₙ. Each of the counters 17₁ to 17ₙ counts the pulse signals having an intensity exceeding each of the threshold values Th₁ to Thₙ for each of the plurality of threshold values Th₁ to Thₙ.

Since the radiation detection device 10 includes the plurality of signal processing units 11 configured as described above, it is possible to discriminate the energy of radiation for each of the plurality of light receiving regions 23. As a result, it is possible to generate a color X-ray image of an object or to measure the density of a plurality of types of materials.

The anode potential correction circuit 12 corrects the anode-side potential of each light receiving region 23 for each of the plurality of light receiving regions 23. Specifically, as illustrated in FIG. 6, the anode potential correction circuit 12 corrects the potential between the anode electrode pad 22A and the resistor R (potential represented by "DAC" in FIG. 6) for each light receiving region 23 such that the gains of the light receiving regions 23 are the same. As a result, even when a voltage of, for example, 46 V is applied to the cathode electrode pad 22B, the voltage is individually applied to each light receiving region 23. Since the signal processing unit 11 has the anode potential correction circuit 12 configured in this way, it is possible to adjust the gain for each of the plurality of light receiving regions 23.

As illustrated in FIG. 14, the cathode potential correction circuit 13 corresponds to a plurality of light receiving regions 23. That is, one cathode potential correction circuit 13 is provided for the plurality of light receiving regions 23. In this embodiment, one cathode potential correction circuit 13 is provided for a plurality of optical semiconductor elements 2. The cathode potential correction circuit 13 collectively corrects the cathode-side potential of each of the plurality of light receiving regions 23 according to the signal output from the temperature sensor 8. Therefore, it is possible to suppress a fluctuation in the gain of the plurality of light receiving regions 23 caused by the temperature of the optical semiconductor element 2.

The threshold value linearity correction circuit 15 corresponds to a plurality of light receiving regions 23. That is, one threshold value linearity correction circuit 15 is provided for the plurality of light receiving regions 23. In this embodiment, one threshold value linearity correction circuit 15 is provided for a plurality of optical semiconductor elements 2. The threshold value linearity correction circuit 15 inputs the threshold values Th₁ to Thₙ to the comparators 16₁ to 16ₙ, respectively. The threshold value linearity correction circuit 15 corrects each of the threshold values Th₁ to Thₙ such that each of the threshold values Th₁ to Thₙ is the same between the plurality of light receiving regions 23 (that is, between the plurality of signal processing units 11). As an example, the threshold value linearity correction circuit 15 corrects each of the threshold values Th₁ to Thₙ on the basis of conversion codes or conversion parameters stored for each of the plurality of signal processing units 11 and for each of the plurality of comparators 16₁ to 16ₙ such that a plurality of threshold values Thₘ (m is an integer from 1 to n) corresponding to each other between the plurality of signal processing units 11 are the same. Therefore, it is possible to suppress variations in the threshold values input to the plurality of comparators 16ₘ corresponding to each other between the plurality of light receiving regions 23 (that is, between the plurality of signal processing units 11).

### [Modification Examples]

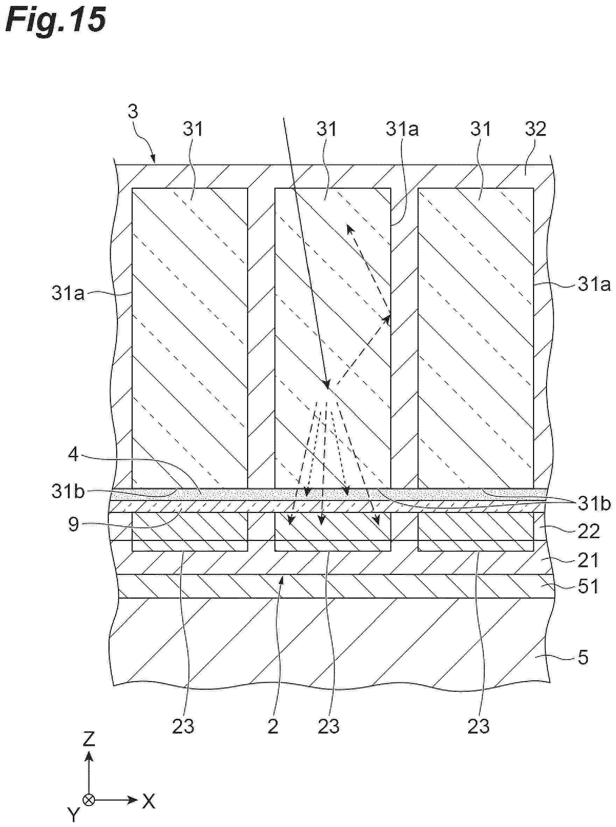

The present disclosure is not limited to the above-described embodiment. For example, as illustrated in FIG. 15, an optical filter layer 9 may be disposed between the optical semiconductor element 2 and the scintillator unit 3. As an example, the optical filter layer 9 is configured by a dielectric multi-layer film formed on the surface of the optical semiconductor element 2 facing the scintillator unit 3. The adhesive layer 4 is disposed between the optical filter layer 9 and the scintillator unit 3. The optical filter layer 9 is in contact with each of the optical semiconductor element 2 and the adhesive layer 4. The adhesive layer 4 is in contact with each of the optical filter layer 9 and the scintillator unit 3. Even in this case, the distance D1 between adjacent light receiving regions 23 is greater than the distance D2 between the light receiving region 23 and the scintillator 31 facing each other. The sum of the thickness of the optical filter layer 9 and the thickness of the adhesive layer 4 is, for example, less than 100 µm. In addition, the optical filter layer 9 may be adhered to a surface of the optical semiconductor element 2 facing the scintillator unit 3.

According to the configuration illustrated in FIG. 15, when light is emitted from a certain scintillator 31 in response to the incidence of radiation, the incidence of light in a desired wavelength band on a light receiving region 23 facing the scintillator 31 is promoted, and the incidence of light on another light receiving region 23 adjacent to the light receiving region 23 is suppressed. As an example, the optical filter layer 9 may be configured to transmit light in a short wavelength band (a dashed line illustrated in FIG. 15) and to cut light in a long wavelength band (a dotted line illustrated in FIG. 15) among the light components emitted by the scintillator 31. In general, the light in the short wavelength band (for example, blue light, ultraviolet light, or the like) has a shorter emission attenuation time constant than the light in the long wavelength band. Therefore, the radiation detector 1 is configured such that the optical semiconductor element 2 detects only the light in the short wavelength band, which makes it possible to improve the radiation dose rate.

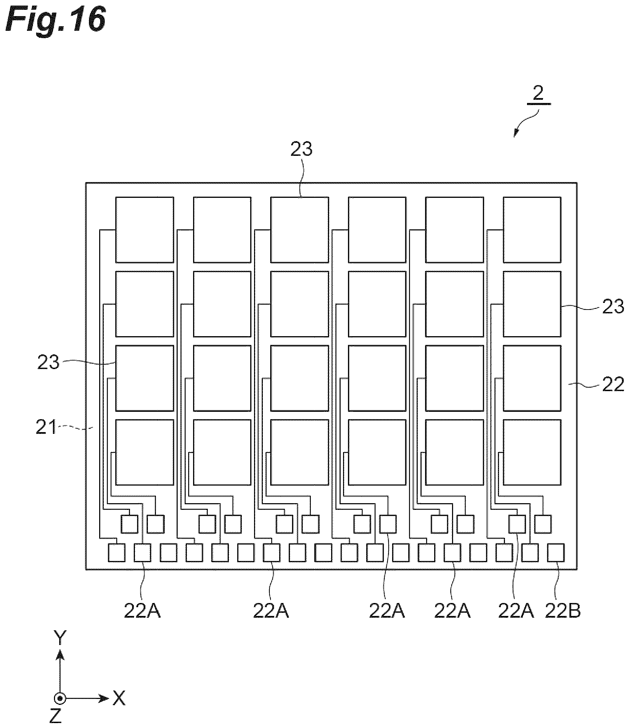

In addition, as illustrated in FIG. 16, a plurality of light receiving regions 23 may be disposed two-dimensionally in the optical semiconductor element 2. In the configuration illustrated in FIG. 16, the plurality of light receiving regions 23 are arranged in a matrix with the X direction as the row direction and the Y direction as the column direction. A plurality of anode electrode pads 22A and the cathode electrode pad 22B are located on one side in the Y direction with respect to the plurality of light receiving regions 23.

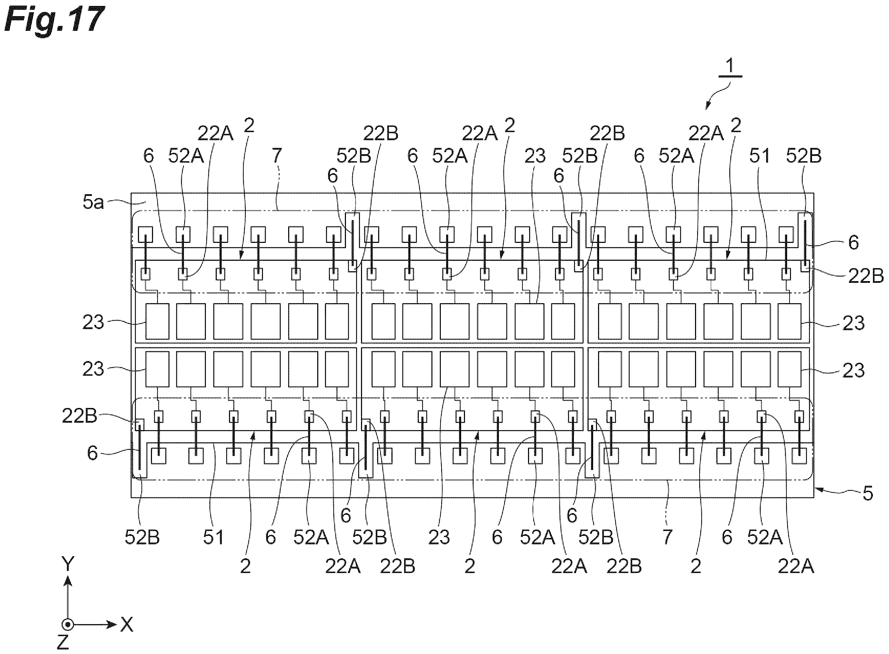

Further, as illustrated in FIG. 17, a plurality of optical semiconductor elements 2 may be mounted on the wiring substrate 5 while being arranged in two rows. In the configuration illustrated in FIG. 17, in a row of a plurality of optical semiconductor elements 2 on one side (the lower side in FIG. 17), a plurality of anode electrode pads 22A and the cathode electrode pad 22B are located on one side in the Y direction with respect to a plurality of light receiving regions 23. In a row of a plurality of optical semiconductor elements 2 on the other side (the upper side in FIG. 17), a plurality of anode electrode pads 22A and the cathode electrode pad 22B are located on the other side in the Y direction with respect to the plurality of light receiving regions 23. In addition, the protective resin member 7 is represented by a two-dot chain line in FIG. 17. Further, in FIG. 17, the illustration of the plurality of scintillator units 3 is omitted.

Furthermore, the optical semiconductor element 2 may be a back-illuminated type. That is, in the semiconductor layer 21, a plurality of P-type semiconductor regions 212 and P⁺-type semiconductor regions 213 may be disposed along the surface of the semiconductor layer 21 opposite to the scintillator unit 3. In this case, the trenches 21c that open to the surface of the semiconductor layer 21 opposite to the scintillator unit 3 and separate the P-type semiconductor regions 212 from each other may be formed in the semiconductor layer 21. Further, in the optical semiconductor element 2 functioning as an SiPM, each light receiving unit 24 may have another configuration such as a configuration in which the N-type and the P-type are reversed. As an example, the N-type semiconductor region 211, the P-type semiconductor region 212, and the P⁺-type semiconductor region 213 may be a P-type semiconductor region, an N⁻-type semiconductor region, and an N-type semiconductor region, respectively. Further, the material forming the semiconductor layer 21 is not limited to silicon and may be a compound semiconductor. Furthermore, in the optical semiconductor element 2, the wiring layer 22 may not be formed on the front surface 21a of the semiconductor layer 21. In addition, in the above-described embodiment, in the wiring substrate 5, the mounting pad 51 is electrically connected to a plurality of common electrode pads 52B. However, the mounting pad 51 may not be electrically connected to the plurality of common electrode pads 52B. Moreover, the radiation detector 1 may include at least one optical semiconductor element 2.

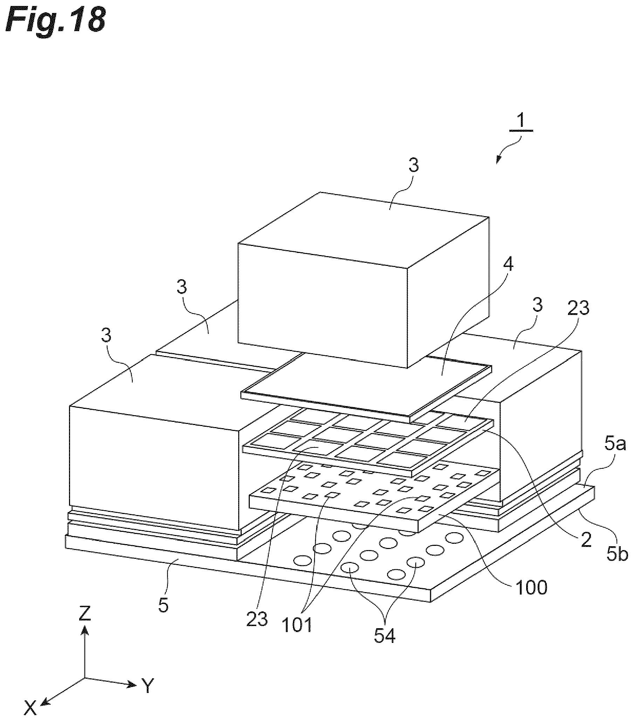

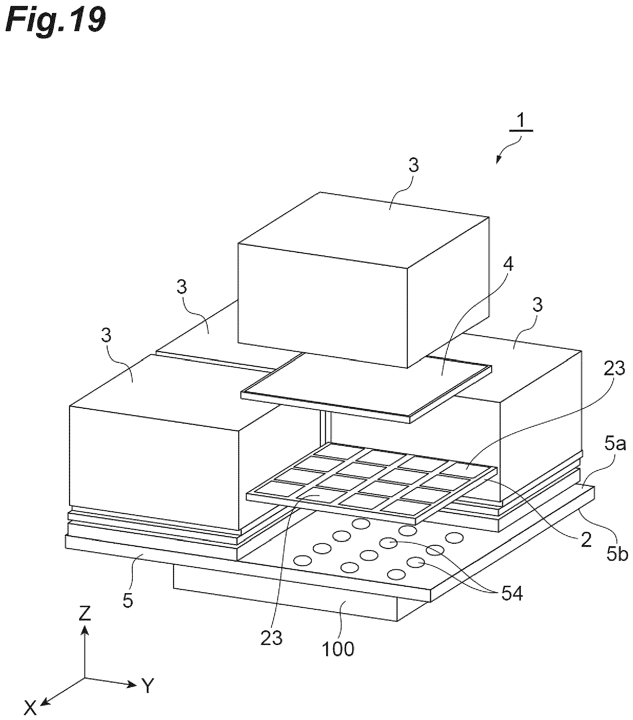

Further, in a configuration in which a plurality of optical semiconductor elements 2 are mounted on the wiring substrate 5, the optical semiconductor elements 2 may be disposed with respect to one optical semiconductor element 2 in four directions. A configuration enabling this disposition of the optical semiconductor elements 2 will be described with reference to FIGS. 18 and 19.

In the configuration illustrated in FIG. 18, when focusing on one optical semiconductor element 2, an application specific integrated circuit (ASIC) 100, the optical semiconductor element 2, the adhesive layer 4, and the scintillator unit 3 are stacked on the front surface 5a of the wiring substrate 5 in this order. The optical semiconductor element 2 has a plurality of light receiving regions 23 arranged in a matrix with the X direction as the row direction and the Y direction as the column direction. The optical semiconductor element 2 is, for example, a back-illuminated type, and a plurality of anode electrode pads (not illustrated) and the cathode electrode pad (not illustrated) are provided on the surface of the optical semiconductor element 2 facing the wiring substrate 5. The ASIC 100 is electrically connected to the wiring substrate 5 through a plurality of bump electrodes 54 and is fixed to the wiring substrate 5. The optical semiconductor element 2 is electrically connected and fixed to the ASIC 100 through a plurality of direct bonding electrodes 101 provided on a surface of the ASIC 100 facing the optical semiconductor element 2. The scintillator unit 3 is fixed to the optical semiconductor element 2 with the adhesive layer 4 interposed therebetween.

In the configuration illustrated in FIG. 19, when focusing on one optical semiconductor element 2, the optical semiconductor element 2, the adhesive layer 4, and the scintillator unit 3 are stacked on the front surface 5a of the wiring substrate 5 in this order. The ASIC 100 is mounted on the rear surface 5b of the wiring substrate 5. The optical semiconductor element 2 has a plurality of light receiving regions 23 arranged in a matrix with the X direction as the row direction and the Y direction as the column direction. The optical semiconductor element 2 is, for example, a front-illuminated type, and a plurality of anode electrode pads (not illustrated) and the cathode electrode pad (not illustrated) drawn out by through electrodes or the like are provided on the surface of the optical semiconductor element 2 facing the wiring substrate 5. The optical semiconductor element 2 is electrically connected and fixed to the wiring substrate 5 through a plurality of bump electrodes 54. The scintillator unit 3 is fixed to the optical semiconductor element 2 with the adhesive layer 4 interposed therebetween.

Further, in the above-described embodiment, one scintillator 31 corresponds to one light receiving region 23. However, one scintillator 31 may correspond to a plurality of light receiving regions 23. In this case, the plurality of light receiving regions 23 may be all of the light receiving regions 23 of the optical semiconductor element 2 or may be some of the light receiving regions 23 of the optical semiconductor element 2. Furthermore, in the above-described embodiment, the scintillator unit 3 has the light reflecting member 32. However, the scintillator unit 3 may not have the light reflecting member 32. That is, the scintillator unit 3 may have at least one scintillator 31 corresponding to the plurality of light receiving regions 23. Even in this case, the distance D1 between adjacent light receiving regions 23 is greater than the distance D2 between the light receiving region 23 and the scintillator 31 facing each other. Therefore, when light is emitted from a certain region in the scintillator 31 in response to the incidence of radiation, the incidence of light on a light receiving region 23 facing the region is promoted, and the incidence of light on a light receiving region 23 adjacent to the light receiving region 23 is suppressed.

As an example, when the scintillator 31 is composed of a plurality of columnar crystals extending in the Z direction or when the scintillator 31 is relatively thin, one scintillator 31 does not need to correspond to one light receiving region 23, and the scintillator unit 3 does not need to have the light reflecting member 32. In these cases, the scintillator unit 3 may further have at least one of a protective film and a light reflecting film covering surfaces other than a surface on the optical semiconductor element 2 side among the surfaces of the scintillator 31. In addition, in one light receiving region 23, the depletion layer 20 may be connected between a plurality of APDs 25.

### Reference Signs List

1: radiation detector, 2: optical semiconductor element, 3: scintillator unit, 4: adhesive layer, 5: wiring substrate, 8: temperature sensor, 9: optical filter layer, 10: radiation detection device, 11: signal processing unit, 12: anode potential correction circuit, 13: cathode potential correction circuit, 14: waveform shaping circuit, 16₁ to 16ₙ: comparator, 17₁ to 17ₙ: counter, 23: light receiving region, 23A: light receiving region (first light receiving region), 23B: light receiving region (second light receiving region), 24: light receiving unit, 25: avalanche photodiode (APD), 26: quenching resistor, 31: scintillator, 31a: front surface, 31b: rear surface, 32: light reflecting member, 51: mounting pad (pad).

## Claims

1. A radiation detector comprising:
an optical semiconductor element including a plurality of light receiving regions;
a scintillator unit disposed on the optical semiconductor element; and
an adhesive layer disposed between the optical semiconductor element and the scintillator unit,
wherein the scintillator unit includes at least one scintillator corresponding to the plurality of light receiving regions,
each of the plurality of light receiving regions includes a plurality of light receiving units connected in parallel to each other,
each of the plurality of light receiving units includes an avalanche photodiode configured to operate in a Geiger mode and a quenching resistor connected in series to the avalanche photodiode, and
a distance between adjacent light receiving regions among the plurality of light receiving regions is greater than a distance between a light receiving region and a scintillator facing each other among the plurality of light receiving regions and the at least one scintillator.

2. The radiation detector according to claim 1,
wherein the adhesive layer is in contact with each of the optical semiconductor element and the scintillator unit.

3. The radiation detector according to claim 1, further comprising:
an optical filter layer disposed between the optical semiconductor element and the scintillator unit,
wherein the adhesive layer is disposed between the optical filter layer and the scintillator unit,
the optical filter layer is in contact with each of the optical semiconductor element and the adhesive layer, and
the adhesive layer is in contact with each of the optical filter layer and the scintillator unit.

4. The radiation detector according to any one of claims 1 to 3,
wherein the distance between the adjacent light receiving regions is equal to or greater than 0.1 mm.

5. The radiation detector according to any one of claims 1 to 4,
wherein a width of each of the plurality of light receiving units is equal to or less than 50 µm.

6. The radiation detector according to any one of claims 1 to 5, further comprising:
a wiring substrate,
wherein a plurality of optical semiconductor elements are mounted on the wiring substrate, and
each of the plurality of optical semiconductor elements is the optical semiconductor element.

7. The radiation detector according to claim 6,
wherein the plurality of optical semiconductor elements are arranged in one direction,
the plurality of light receiving regions are arranged in the one direction in each of the plurality of optical semiconductor elements,
the plurality of light receiving regions include a pair of first light receiving regions located at both ends in the one direction and a plurality of second light receiving regions located between the pair of first light receiving regions, and
a width of each of the pair of first light receiving regions is smaller than a width of each of the plurality of second light receiving regions in the one direction.

8. The radiation detector according to claim 6 or 7,
wherein the plurality of optical semiconductor elements are directly mounted on the wiring substrate.

9. The radiation detector according to claim 8,
wherein the plurality of optical semiconductor elements are fixed onto a common pad included in the wiring substrate.

10. The radiation detector according to any one of claims 1 to 9,
wherein the at least one scintillator is a plurality of scintillators corresponding to the plurality of light receiving regions.

11. The radiation detector according to claim 10,
wherein the scintillator unit further includes a light reflecting member covering surfaces other than a surface on the optical semiconductor element side among surfaces of each of the plurality of scintillators.

12. A radiation detection device comprising:
the radiation detector according to any one of claims 1 to 11; and
a plurality of signal processing units corresponding to the plurality of light receiving regions, and configured to process a pulse signal output from each of the plurality of light receiving regions,
wherein each of the plurality of signal processing units includes a waveform shaping circuit, a plurality of comparators, and a plurality of counters,
the waveform shaping circuit shapes a waveform of the pulse signal such that a pulse width is shortened,
each of the plurality of comparators compares an intensity of the pulse signal input from the waveform shaping circuit with each of a plurality of different threshold values, and
each of the plurality of counters counts the pulse signals having an intensity exceeding each of the plurality of threshold values for each of the plurality of threshold values.

13. The radiation detection device according to claim 12,
wherein each of the plurality of signal processing units further includes an anode potential correction circuit, and
the anode potential correction circuit corrects an anode-side potential of each of the plurality of light receiving regions for each of the plurality of light receiving regions.

14. The radiation detection device according to claim 12 or 13, further comprising:
a cathode potential correction circuit corresponding to the plurality of light receiving regions,
wherein the cathode potential correction circuit collectively corrects a cathode-side potential of each of the plurality of light receiving regions according to a signal output from a temperature sensor further included in the radiation detector.

15. The radiation detection device according to any one of claims 12 to 14, further comprising:
a threshold value linearity correction circuit corresponding to the plurality of light receiving regions,
wherein the threshold value linearity correction circuit corrects each of the plurality of threshold values such that each of the plurality of threshold values is the same between the plurality of light receiving regions.
